(19) Europäisches Patentamt
European Patent Office
Office européen des brevets

(11) **EP 4 393 971 A1**

(12) **EUROPEAN PATENT APPLICATION**
published in accordance with Art. 153(4) EPC

(43) Date of publication:
**03.07.2024 Bulletin 2024/27**

(21) Application number: **22861244.6**

(22) Date of filing: **18.08.2022**

(51) International Patent Classification (IPC):
**C08F 290/06** (2006.01)     **C09J 4/02** (2006.01)
**C09J 11/06** (2006.01)      **C09J 11/08** (2006.01)
**C08F 2/44** (2006.01)       **G09F 9/00** (2006.01)

(52) Cooperative Patent Classification (CPC):
**C08F 2/44; C08F 290/06; C09J 4/00; C09J 11/06;
C09J 11/08; G09F 9/00**

(86) International application number:
**PCT/JP2022/031233**

(87) International publication number:
**WO 2023/026956 (02.03.2023 Gazette 2023/09)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **26.08.2021 JP 2021137824**

(71) Applicant: **Dexerials Corporation
Shimotsuke-shi, Tochigi 323-0194 (JP)**

(72) Inventors:
• **TOMOBE Akira
Shimotsuke-shi, Tochigi 323-0194 (JP)**
• **WAKAIRO Masakatsu
Shimotsuke-shi, Tochigi 323-0194 (JP)**
• **NAKATA Yoshiaki
Shimotsuke-shi, Tochigi 323-0194 (JP)**

(74) Representative: **Müller-Boré & Partner
Patentanwälte PartG mbB
Friedenheimer Brücke 21
80639 München (DE)**

(54) **PHOTOCURABLE MATERIAL AND IMAGE DISPLAY DEVICE**

(57)     In producing an image display device including an image display panel and a front panel that are laminated via a transparent resin layer, when a photocurable material for forming the transparent resin layer is used as a dam agent or a fill agent, the photocurable material includes a component (a), which is a (meth)acrylic acid ester component; a component (b), which is a plasticizer component; and a component (c), which is a photopolymerization initiator component in order to make it difficult to visually recognize a knit line between the dam portion and the fill portion of the transparent resin layer after curing. A difference between the refractive index of the photocured product of the component (a), which is the (meth)acrylic acid ester component and the refractive index of the plasticizer component as the component (b) is 0.02 or less.

FIG. 1

10

EP 4 393 971 A1

**Description**

Technical Field

The present invention relates to a photocurable material and an image display device.

Background Art

A typical image display device has a structure in which a front panel and an image display panel are laminated via a transparent resin layer, wherein the transparent resin layer is a cured product of a photocurable resin composition. This structure is usually produced by a method (so-called a dam fill method) including: applying a photocurable resin composition functioning as a dam agent to an outer edge of an image display panel to form a photocurable dam portion; then applying the same composition as before or a different photocurable resin composition functioning as a filling agent to an area surrounded by the photocurable dam portion to form a photocurable fill portion; then bonding the image display panel and a front panel to each other, and irradiating and photocuring the photocurable dam portion and the photocurable fill portion with ultraviolet rays to form a transparent resin layer (PTL 1).

In the dam portion and the fill portion of the transparent resin layer of the image display device produced by such a dam fill method, a difference in refractive index can occur between the dam portion and the fill portion. This difference is due to differences in the type and the added proportional amounts of the components of the photocurable resin composition used, or due to the occurrence of migration of low molecular weight materials between the dam portion and the fill portion. This difference in refractive index raises a concern that a boundary line therebetween could be visually recognized as a so-called knit line.

Therefore, in PTL 1, in order to prevent the knit line between the dam portion and the fill portion from being visually recognized, it is recommended that, when the curable resin composition functioning as a dam agent and the curable resin composition functioning as a fill agent are prepared, the difference in transmittance at 400 nm between the two compositions is adjusted to 5% or less, the difference in refractive index to 0.01% or less, and the difference in haze to 0.2% or less.

Citation List

Patent Literature

PTL 1: WO2014/168173

Summary of Invention

Technical Problem

Incidentally, with regard to the knit line between the dam portion and the fill portion in the transparent resin layer of the image display device, the visibility of the transparent resin layer after it is cured is the issue.

However, PTL 1 focuses on the visibility of the boundary line before the compositions are cured, when contact is made between the curable resin composition used as the dam agent and the curable resin composition used as the fill agent, and it cannot be said that the knit line in the transparent resin layer after curing has been studied in PTL 1. Moreover, PTL 1 just recommends that the "difference in transmittance at 400 nm", the " difference in refractive index", and the "difference in haze" between the curable resin composition used as the dam agent and the curable resin composition used as the fill agent before the compositions are cured should not exceed respective predetermined values, but PTL 1 does not show a specific index for how to select constituent components.

An object of the present invention is to solve the above-mentioned conventional problems, and is to make it difficult to visually recognize a knit line between a dam portion and a fill portion of a transparent resin layer after the compositions are cured when the photocurable material for forming a transparent resin layer is used as a dam agent or a fill agent in the production of an image display device formed by laminating, via the transparent resin layer, an image display panel and a front panel.

Solution to Problem

The present inventors have found that the above-described object can be achieved by configuring a photocurable material for forming a dam portion and/or a fill portion of a transparent resin layer of an image display device, in which an image display panel and a front panel are laminated via the transparent resin layer, from a plasticizer and a photopolymerization initiator in addition to a specific photocurable component, and making the difference between a refractive index of a photocured product of the photocurable component and a refractive index of the plasticizer equal to or less than a predetermined value, thereby completing the present invention.

Specifically, the present invention provides a photocurable material for forming a transparent resin layer of an image display device, in which an image display panel and a front panel are laminated via the transparent resin layer, and the photocurable material includes the following components (a) to (c):

> a component (a) being a (meth)acrylic acid ester component;
> a component (b) being a plasticizer component; and
> a component (c) being a photopolymerization initiator component.

Here, a difference between a refractive index of a photocured product of the (meth)acrylic acid ester component as the component (a) and a refractive index of the plasticizer component as the component (b) is 0.02 or less.

Furthermore, the present invention provides an image display device in which an image display panel and a front panel are laminated via a transparent resin layer, and the transparent resin layer is a photocured product of the photocurable material of the present invention described above.

Advantageous Effects of Invention

The photocurable material of the present invention includes the component (a), which is the (meth)acrylic acid ester component, the component (b), which is the plasticizer component, and the component (c), which is the photopolymerization initiator component, and the difference between the refractive index of the photocured product of the component (a), which is the (meth)acrylic acid ester component, and the refractive index of the component (b), which is the plasticizer component, is set to be 0.02 or less. In general, when a easily migrating component in the component (a), which is the (meth)acrylic acid ester component, migrates from either the dam portion or the fill portion of the transparent resin layer to the other portion, there is a concern that a boundary line between the dam portion and the fill portion is visually recognized as a knit line. As described above, in the photocurable material of the present invention, the difference between the refractive index of the photocured product of the component (a), which is the (meth)acrylic acid ester component, and the refractive index of the component (b), which is the plasticizer component, is as very small as 0.02 or less. Therefore, it can be expected that the boundary line between the dam portion and the fill portion of the transparent resin layer is made to be difficult to visually recognize as a knit line.

Brief Description of Drawings

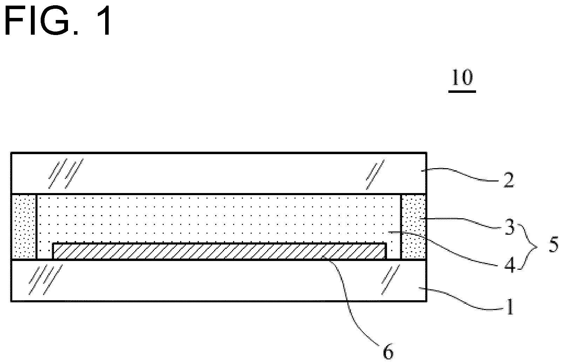

[FIG. 1] FIG. 1 is a schematic cross-sectional view of an embodiment of an image display device.

Description of Embodiments

Hereinafter, a photocurable material of the present invention will be described in detail.

The photocurable material of the present invention is preferably used for producing a transparent resin layer 5 of an image display device 10 of FIG. 1. Here, the image display device 10 has a structure in which an image display panel 1 and a front panel 2 are laminated via the transparent resin layer 5 that is composed of a dam portion 3 and a fill portion 4, which is surrounded by the dam portion 3. In general, a polarizing plate 6 is disposed on the surface of the image display panel 1 on the transparent resin layer 5 side. The photocurable material of the present invention may be applied to the formation of both the dam portion 3 and the fill portion 4 of the transparent resin layer 5 in the image display device 10, or may be applied to the formation of either the dam portion 3 or the fill portion 4. Note that the image display device to which the photocurable material of the present invention can be applied is not limited to the aspect of FIG. 1.

<Refractive index of photocurable material>

The photocurable material of the present invention includes a component (a), which is a (meth)acrylic acid ester component which is a photopolymerization component, a component (b), which is a plasticizer component, and a component (c), which is a photopolymerization initiator component. The photocurable material of the present invention is a material in which the difference between the refractive index of a photocured product of the component (a), which is the (meth)acrylic acid ester component, and the refractive index of the component (b), which is the plasticizer component, is adjusted to be 0.02 or less, preferably 0.015 or less.

If the viscosity of the photocurable material of the present invention is too low, the photocurable material tends to easily wet and spread over an area wider than the intended area when the photocurable material is coated, and control of the coating area tends to be difficult. If the viscosity is too high, the wetting and spreading properties of the photocurable material would decrease, and thus the coating of the photocurable material would tend to be difficult. Therefore, the viscosity of the photocurable material is preferably 1,000 to 8,000 mPa·s at 25°C, more preferably 2,000 to 7,000 mPa·s. Viscosity can be measured using a typical rotational viscometer (cone plate rheometer with cone of C35/2 and rotational speed of 10 rpm), at 25°C.

As described above, even if an easily migrating component in the component (a), which is the (meth)acrylic acid ester component, before curing migrates from either the dam portion or the fill portion to the other portion, since the difference between the refractive index of the photocured product of the component (a), which is the (meth)acrylic acid ester component, and the refractive index of the plasticizer component as the component (b) is as very small as 0.02 or less, the boundary line between the dam portion and the fill portion of the transparent resin layer after photocuring is made to be difficult to visually recognize as a knit line.

(Measurement of refractive index of photocured product of component (a))

The photocured product of the component (a), which is the (meth)acrylic acid ester component and is the object of refractive index measurement, is obtained by mixing 100 parts by mass of the component (a), which is the (meth)acrylic acid ester component with 0.5 to 1.0 parts by mass of the component (c), which is the photopolymerization initiator component, and photocuring the mixture by irradiation with light such as ultraviolet rays. Note that the refractive index of the component (b), which is the plasticizer component and is the other component that is the object of the refractive index measurement, may be measured as is without special pretreatment such as curing treatment. When the photocured product to be measured for the refractive index is a solid, the refractive index can be measured using a commercially available Abbe type refractive index measuring apparatus. When the photocured product to be measured for the refractive index is a high-viscosity liquid, the refractive index can be measured using a digital refractometer of an optical-refraction critical-angle detection system.

As the photocuring conditions of the component (a), which is the (meth)acrylic acid ester component, conditions in which the degree of curing calculated by FT-IR method is 90% or more, preferably 95% or more, can be appropriately selected. Examples of the photocuring conditions may include light irradiation with the metal halide lamp at 5,000 mJ/cm$^2$ or more.

Specifically, the refractive index of the photocured product of the component (a), which is the (meth)acrylic acid ester component, can be measured as follows. When the component (a), which is the (meth)acrylic acid ester component, contains a plurality of components, a photocured product derived from a mixture of the plurality of components is the measured target. The refractive index of the photocured product of the component (a), which is the (meth)acrylic acid ester component, can be adjusted by changing the type and number of (meth)acrylic acid esters used as the (meth)acrylic acid ester component, and the blending proportion thereof.

Photocuring of the component (a), which is the (meth)acrylic acid ester component, can be appropriately performed according to a known method depending on the type thereof and the type of the polymerization initiator. Photocuring can usually be performed by irradiating the component (a), which is the (meth)acrylic acid ester component, having a thickness of 0.3 mm with UV light emitted from a metal halide lamp so that the integrated light amount becomes 3,000 to 5,000 mJ/cm$^2$. In this case, the photocured product is one cured so that the overall average degree of reaction (degree of curing) thereof is 90% or more (preferably 95% or more). The degree of reaction of the entire photocured product means, for example, the degree of reaction measured for the cured product formed in the thickness of 0.3 mm.

Here, the degree of reaction is a numerical value defined as a proportion (consumption proportion) of the abundance of the (meth)acryloyl group after photocuring to the abundance of the (meth)acryloyl group in the component (a), which is the (meth)acrylic acid ester component, before photocuring. The higher the numerical value of degree of reaction is, the more the reaction has proceeded. Specifically, the degree of reaction can be calculated by substituting the height (X), from the baseline, of the absorption peak between 1640 and 1620 cm$^{-1}$ in the FT-IR measurement chart of the photocurable material before photocuring and the height (Y), from the baseline, of the absorption peak between 1640 and 1620 cm$^{-1}$ in the FT-IR measurement chart of the photocurable material (photocured layer) after photocuring into the following equation.

$$\text{Degree of reaction } [\%] = [(X - Y)/X] \times 100$$

(Measurement of refractive index of plasticizer component of component (b))

A case where the plasticizer component is a single component and a case where the plasticizer component contains a plurality of plasticizers (total refractive index) will be separately described.

(Specific measurement example of refractive index when component (b) contains only a single plasticizer component)

Since the plasticizer component is usually a high-viscosity liquid, the refractive index of the plasticizer component can be measured by setting the plasticizer component to be measured in a prismatic portion of a commercially available digital refractometer (for example, RX-5000$\alpha$ of Atago Co., Ltd.) of an optical-refraction critical-angle detection system.

(Specific measurement example of refractive index when component (b) contains a plurality of plasticizers)

The refractive index R of each plasticizer within the plurality of plasticizers is measured in the same way as described above. A numerical value A is obtained by multiplying the refractive index R of each plasticizer by its abundance (parts by mass) M, and a numerical value B is obtained by adding all the obtained numerical values A of the respective plasticizers. To obtain the total refractive index, the numerical value B is divided by the total abundance C of the plurality of plasticizers. As a specific example, when the plasticizer component as the component (b) contains two types of plasticizers (a first plasticizer and a second plasticizer), the refractive index is calculated as follows.

That is, suppose a case where the plasticizer component as the component (b) contains a first plasticizer having a refractive index RIa and a second plasticizer having a refractive index RIb, and the abundance of the first plasticizer is W1 parts by mass and the abundance of the second plasticizer is W2 parts by mass. In this case, the refractive index of the plasticizer component as the component (b) is calculated according to the following equation.

Refractive index of component (b), which is plasticizer component = (RIa $\times$ W1 + RIb $\times$ W2)/(W1 + W2)

Hereinafter, the components of the photocurable material of the present invention will be described for each component.

<Component (a)>

The photocurable material of the present invention contains a (meth)acrylic acid ester component as the component (a). Herein, the term "(meth)acrylic acid ester" used in the present invention includes acrylic acid esters and methacrylic acid esters.

The component (a), which is the (meth)acrylic acid ester component, preferably contains one or more types of polyfunctional (meth)acrylate oligomers and one or more types of monofunctional (meth)acrylate monomers. The reason why the polyfunctional (meth)acrylate oligomer is contained is to maintain the film-forming properties of the photocurable material when the transparent resin layer is produced from the photocurable material, and the reason why the monofunctional (meth)acrylate monomer is contained is to adjust the coating properties and viscosity of the photocurable material and to impart good adhesion properties to the transparent resin layer containing the above-described oligomers.

Preferred examples of the polyfunctional (meth)acrylate oligomer include a polyfunctional (meth)acrylate oligomer having a dielectric constant of 4.0 or more at 100 kHz. If the dielectric constant is less than 4.0, the moisture permeability of the cured product of the photocurable material tends to become too low. The dielectric constant can be measured by a typical LCR meter.

Preferred examples of the polyfunctional (meth)acrylate oligomer having a dielectric constant of 4.0 or more at 100 kHz include a polyfunctional polyether-based urethane (meth)acrylate oligomer, a polyfunctional polyester-based urethane oligomer, and a polyfunctional hydroxy group-containing oligomer. Among these, a bifunctional polyether-based urethane (meth)acrylate oligomer is preferable from the viewpoint of imparting good moisture permeability to the cured product of the photocurable material.

The weight-average molecular weight of the polyfunctional (meth)acrylate oligomer is preferably 20,000 to 50,000, more preferably 30,000 to 40,000, because if it is too small, the cured product of the photocurable material would become too hard and display unevenness will occur when the photocurable material is applied to a display device. On the other hand, if it is too large, there is a concern that viscosity that is appropriate for handling cannot be imparted to the photocurable material. The weight-average molecular weight can be measured using a typical gel-permeation chromatography device (GPC device).

In addition, the viscosity of the polyfunctional (meth)acrylate oligomer is preferably 20,000 to 60,000 mPa·s, more preferably 30,000 to 50,000 mPa·s, at 60°C, because if it is too low, the cured product of the photocurable material will become too hard and display unevenness occurs when the product is applied to a display device, and if it is too high, viscosity that is appropriate for handling would not be able to be imparted to the photocurable material. The viscosity can be measured using a typical B-type viscometer.

The glass transition temperature of the polyfunctional (meth)acrylate oligomer is preferably -30 to 10°C, more preferably -20 to 0°C, because if it is too low, good adhesion properties cannot be imparted to the photocurable material, and if it is too high, the cured product of the photocurable material will become too hard and display unevenness tends to occur when the cured product is applied to a display device. The glass transition temperature can be measured using a typical differential scanning calorimeter.

The content of the polyfunctional (meth)acrylate oligomer having a dielectric constant of 4.0 or more at 100 kHz in the component (a), which is the (meth)acrylic acid ester component, is preferably 20% by mass to 40% by mass, more preferably 20% by mass to 30% by mass, from the viewpoint of adhesion properties and reactivity of the photocurable material.

The component (a), which is the (meth)acrylic acid ester component, may contain a polyfunctional (meth)acrylate oligomer other than the polyfunctional (meth)acrylate oligomer having a dielectric constant of 4.0 or more at 100 kHz, for example, a polyether-modified polyfunctional (meth)acrylate oligomer or the like, as long as the advantageous effects of the present invention are not impaired.

As the monofunctional (meth)acrylate monomer contained in the component (a), which is the (meth)acrylic acid ester component, a hydroxy group-containing (meth)acrylate monomer is preferably exemplified in order to impart high polarity to the photocurable material, to improve the moisture permeability of the cured product of the photocurable material, and to release moisture generated from the polarizing plate to the outside of the image display device. The hydroxy group-containing (meth)acrylate monomer may contain two or more hydroxy groups, but preferably has one hydroxy group from the viewpoint of avoiding a decrease in water resistance and a decrease in adhesive strength of the photocured product.

Examples of the hydroxy group-containing (meth)acrylate monomer include a hydroxyalkyl (meth)acrylate monomer. The number of carbon atoms in the alkyl group is not particularly limited and is generally C1 to 12, preferably C1 to 6. Specific examples thereof include methyl, ethyl, propyl, isopropyl, butyl, isobutyl, sec-butyl, tert-butyl, pentyl, hexyl, and 2-ethylbutyl. Specific examples of the hydroxyalkyl (meth)acrylate monomer include 2-hydroxyethyl (meth)acrylate, 1-hydroxyethyl (meth)acrylate, 2-hydroxypropyl (meth)acrylate, 3-hydroxypropyl (meth)acrylate, 1-hydroxypropyl (meth)acrylate, 4-hydroxybutyl (meth)acrylate, and phenyl glycidyl ether (meth)acrylate. Among these, 2-hydroxyethyl (meth)acrylate and particularly 4-hydroxybutyl (meth)acrylate are preferable from the viewpoint of efficiently enhancing the moisture permeability of the photocured product of the photocurable material.

The component (a), which is the (meth)acrylic acid ester component, may contain a (meth)acrylate monomer that does not contain a hydroxy group as long as the advantageous effects of the invention are not impaired. Examples of the (meth)acrylate monomer that does not contain a hydroxy group include a chain hydrocarbon group-containing type and a cyclic hydrocarbon group-containing type. For example, an alkyl (meth)acrylate monomer, a cycloalkyl or bicycloalkyl (meth)acrylate monomer, or a heterocycloalkyl or heterobicycloalkyl (meth)acrylate monomer can be mentioned. Preferred examples of the alkyl (meth)acrylate monomer include an isostearyl acrylate monomer and a lauryl acrylate monomer. Preferred examples of the cycloalkyl or bicycloalkyl (meth)acrylate monomer include an isobornyl acrylate monomer. Preferred examples of the heterocycloalkyl or heterobicycloalkyl (meth)acrylate monomer include a morpholyl acrylate monomer.

The content of the monofunctional (meth)acrylate monomer such as a hydroxy group-containing (meth)acrylate monomer in the component (a), which is the (meth)acrylic acid ester component, is preferably 25% by mass or more, more preferably 50% by mass or more, in order to improve the moisture permeability of the cured product of the photocurable material, as described above.

The content of the component (a), which is the (meth)acrylic acid ester component, in the photocurable material is preferably 20% by mass to 40% by mass, more preferably 25% by mass to 35% by mass. This range is preferred because if the content is too small, it is difficult to impart a viscosity that is appropriate for handling to the photocurable material, and if it is too large, there is a concern that the shrinkage ratio at the time of curing of the photocurable material will become too large.

The difference in refractive index between the photocured products of the one or more types of polyfunctional (meth)acrylate oligomers and the one or more types of monofunctional (meth)acrylate monomers in the component (a), which is the (meth)acrylic acid ester component, [i.e., the difference in refractive index within the component (a)] is preferably 0.02 or less, more preferably 0.015 or less, from the viewpoint of migration from either the dam portion or the fill portion to the other portion.

The photocured product of each of the polyfunctional (meth)acrylate oligomer and the monofunctional (meth)acrylate monomer is obtained by mixing 0.5 parts by mass to 1.0 part by mass of the photopolymerization initiator component as the component (c) with 100 parts by mass of each oligomer or monomer and photocuring the mixture. As the photocuring conditions, conditions in which the degree of curing calculated by FT-IR method is 90% or more, preferably 95% or more, can be appropriately selected. As an example, the curing condition can be exposure with the metal halide lamp at 5,000 mJ/cm$^2$ or more. Furthermore, in the present invention, the refractive index can be measured using a commercially available Abbe type refractive index measuring apparatus.

<Component (b)>

The photocurable material of the present invention contains a plasticizer component as the component (b). The plasticizer itself does not photocure by light irradiation, and the plasticizer imparts flexibility to the photocured product after photocuring. From the viewpoint of compatibility with other components, such a plasticizer preferably contains either one type of a polyether-based polyol or a polyester-based polyol. It is more preferable that the plasticizer contain a polyether-based polyol. General polymers that are miscible with these plasticizer components can also be used as the plasticizer. As the polymer that can be used as such a plasticizer, a polymer that has a small refractive index difference with respect to the plasticizer component as the component (b) used in combination can be preferably used. For example, a hydroxyl group-containing polymer can be presented as an example.

As the polyether-based polyol, for example, a polyether polyol obtained by performing addition polymerization of an alkylene oxide with a polyol such as ethylene glycol, propylene glycol, glycerin, or trimethylolpropane can be used. The alkylene oxide is not particularly limited, and examples thereof include ethylene oxide, propylene oxide, and butylene oxide.

Examples of commercially available polyether-based polyols include "ADEKA POLYETHER" manufactured by ADEKA Corporation. More specifically, "P series" which includes propylene oxide (PO) adducts of propylene glycol, "BPX series" which includes PO adducts of bisphenol A, "G series" which includes PO adducts of glycerin, "T series" which includes PO adducts of trimethylolpropane, "EDP series" which includes PO adducts of ethylenediamine, "SP series" which includes PO adducts of sorbitol, "PR series" which includes random copolymers of propylene glycol, ethylene oxide, and propylene oxide, and "CM series" obtained by adding a propylene oxide-ethylene oxide block copolymer to propylene glycol are exemplified.

The number-average molecular weight of the polyether-based polyol is preferably 500 to 8,000, more preferably 1,000 to 5,000. This range is preferred because if the number-average molecular weight is too small, exudation may occur from the cured product of the photocurable material, and if it is too large, there is a concern that viscosity that is appropriate for handling cannot be imparted to the photocurable material. The number-average molecular weight can be measured using a typical gel-permeation chromatography device (GPC device).

As the polyester-based polyol, for example, a polyester polyol obtained by subjecting a dicarboxylic acid and a diol to a polycondensation reaction can be used. Examples of the dicarboxylic acid include aliphatic carboxylic acids such as adipic acid, azelaic acid, sebacic acid, and dodecanedioic acid; and aromatic carboxylic acids such as terephthalic acid and isophthalic acid. Examples of the diol include diols having a linear structure such as ethylene glycol, 1,4-butanediol, 1,6-hexanediol, 1,9-nonanediol, and diethylene glycol; 1,2-propylene glycol, 1,3-butylene glycol, 2-methyl-1,3-propanediol, neopentyl glycol, 3-methyl-1,5-pentadiol, 2,2-dimethyl-1,3-propanediol, and 2-methyl-1,8-octanediol.

Examples of commercially available products of the polyester-based polyol include "P-1010", "P-2010", "P-3010", and "P-2050" (manufactured by Kuraray Co., Ltd.), "OD-X-102", "OD-X-668", and "OD-X-2068" (manufactured by DIC Corporation), and "NS-2400", "YT-101", "F7-67", "#50", "F1212-29", "YG-108", "V14-90", and "Y65-55" (manufactured by ADEKA Corporation).

The number-average molecular weight of the polyester-based polyol is preferably 500 to 8,000, more preferably 1,000 to 5,000. This range is preferred because if the number-average molecular weight is too small, exudation may occur from the cured product of the photocurable material, and if it is too large, there is a concern that viscosity that is appropriate for handling cannot be imparted to the photocurable material.

The content of the plasticizer component as the component (b) in the photocurable material is preferably 30% by mass to 60% by mass, more preferably 40% by mass to 50% by mass. This range is preferred because if the content is too small, sufficient flexibility required for application of the cured product of the photocurable material as a bonding agent for an image display device will not be obtained, and if it is too large, there is a concern that sufficient adhesive strength cannot be imparted to the photocurable material.

When the plasticizer component as the component (b) contains two or more types of plasticizers, the difference in refractive index between them [i.e., the difference in refractive index within the component (b)] is preferably 0.03 or less, more preferably 0.02 or less, from the viewpoint of suppressing migration from either the dam portion or the fill portion to the other portion. Here, the preferable upper limit (0.03 or less) of the difference in refractive index within the component (b) is set higher than the preferable upper limit (preferably 0.02 or less) of the difference in refractive index within the component (a). This is because, the plasticizer component as the component (b) has a higher viscosity than the component (a) and hence has difficulty in flowing.

<Component (c)>

The photocurable material of the present invention contains a photopolymerization initiator according to the polymerization system as the component (c). Among these, it is preferable that the photocurable material contain a photoradical polymerization initiator from the viewpoint of imparting high reactivity to the photocurable material. It is more preferable that the photoradical polymerization initiator contain at least one of an alkylphenone-based photopolymerization initiator and an acylphosphine oxide-based photopolymerization initiator. Examples of the alkylphenone-based photopolymerization initiator that can be used include 1-hydroxycyclohexylphenyl ketone (Omnirad 184 manufactured by IGM Resins BV Corporation), and 2-hydroxy-1-{4-[4-(2-hydroxy-2-methyl-propionyl)benzyl]phenyl}-2-methylpropan-1-one (Omnirad 127 manufactured by IGM Resins BV Corporation). Examples of the acylphosphine oxide-based photopolymerization initiator that can be used include 2,4,6-trimethylbenzoyldiphenylphosphine oxide (SPEEDCURE TPO manufactured by Lambson Ltd.). Other examples of the photopolymerization initiator include benzophenone and acetophenone.

In the case where the component (c) is a photoradical polymerization initiator, the content of the photopolymerization initiator as the component (c) in the photocurable material of the present invention is preferably 0.2 parts by mass to 2 parts by mass, more preferably 0.5 parts by mass to 1 part by mass, with respect to 100 parts by mass of the component (a), which is the (meth)acrylic acid ester component, described above. Setting the content of the component (C) to be within such a range makes it possible to more effectively prevent insufficient curing at the time of light irradiation, and to more effectively prevent an increase in generation of outgas due to the polymerization reaction. One type of the photopolymerization initiator may be used alone, or two or more types thereof may be used in combination. When two or more types of photopolymerization initiators are used in combination, it is preferable that the total amount thereof satisfy the above-described range.

<Component (d)>

The photocurable material of the present invention may contain a known filler as the component (d), in accordance with the use application of the photocurable material and the like. In particular, silica is preferably contained as the filler. The reason for this preference is that a thixotropic ratio of preferably 2 to 5, more preferably 2.5 to 3.5, can be imparted to the photocurable material by incorporating silica, and as a result, the photocurable material can serve as a useful dam agent. Specifically, if the thixotropic ratio is too small, the shape of the photocurable material will become difficult to retain, and if it is too large, the dischargeability of the photocurable material from a dispenser or the like will deteriorate. Here, the thixotropic ratio is calculated from a viscosity measured using a typical rotational viscometer (cone plate rheometer at 25°C with cone of C35/2 and rotational speed of 10 rpm), and is specifically defined as a numerical value obtained by dividing the viscosity thereof at a rotational speed of 1 rpm at 25°C by the viscosity thereof at a rotational speed of 10 rpm.

The mean particle diameter of such silica is preferably 7 nm or more and 40 nm or less, more preferably 10 nm or more and 20 nm or less. This range is preferred because if the mean particle diameter is too small, a risk of secondary aggregation in the photocurable material increases, and if it is too large, there is a possibility that sufficient thixotropy cannot be imparted to the photocurable material. The mean particle diameter can be measured using a typical laser diffraction particle size distribution analyzer.

The surface of the silica as the component (d) is preferably subjected to a hydrophobic treatment. The photocurable material containing the hydrophobized silica can exhibit good thixotropy without impairing the moisture permeability and transparency of the cured product thereof. As the hydrophobic treatment, a known alkylsilylation treatment on silica is preferably mentioned. Among these, a C12 to C18 higher alkylsilylation treatment, in particular, a hexadecylsilylation treatment as described below, is preferable.

The hexadecylsilylation treatment on silica can be performed according to a conventional method. For example, the hexadecylsilylation treatment can be performed by a polycondensation reaction of a silanol having a hexadecyl group to a hydroxyl group that is present on the surface of a silica filler with an untreated surface.

Furthermore, the BET specific surface area of the filler (particularly silica) of the component (d) is preferably 100 $m^2$/g or more and 300 $m^2$/g or less, more preferably 130 $m^2$/g or more and 200 $m^2$/g or less. This range is preferred because if the BET specific surface area is too small, there is a possibility that sufficient thixotropy cannot be imparted to the photocurable material, and if it is too large, a risk of secondary aggregation in the photocurable material tends to become high. The BET specific surface area can be measured by a so-called BET method.

The content of the filler (particularly silica) of the component (d) in the photocurable material is preferably 5% by mass or more and 15% by mass or less, more preferably 5% by mass or more and 10% by mass or less. This range is preferred because if the content is too small, sufficient thixotropy cannot be obtained, and if it is too large, there is a concern that the transparency of the cured product cannot be maintained.

<Other components of photocurable material>

In addition to the above-described components (a) to (d), the photocurable material of the present invention may contain known additives for resins such as an antioxidant, a solvent, a ultraviolet absorber, a colorant, or an organic or inorganic filler, within a range in which the advantageous effects of the present invention are not impaired.

<Method for producing photocurable material>

The photocurable material of the present invention can be prepared by uniformly mixing the above-described respective components according to a known mixing method.

<Image display device>

FIG. 1 illustrates the image display device 10 formed by laminating the image display panel 1 and the front panel 2 via the transparent resin layer 5 composed of the fill portion 4 and the dam portion 3 surrounding the outer periphery of the fill portion 4. The photocurable material of the present invention can be used appropriately as a material for forming the dam portion 3 or the fill portion 4 or both. As described above, applying the photocurable material of the present invention to the transparent resin layercan make it difficult to visually recognize the knit line at the boundary line between the dam portion 3 and the fill portion 4. A polarizing plate 6 may be disposed on the surface of the image display panel that is in contact with the transparent resin layer 5. Such an image display device is also an aspect of the present invention, but the image display device of the present invention is not limited to the aspect shown in FIG. 1.

In the case where the transparent resin layer 5 is composed of the fill portion 4 that is present at a position corresponding to a display portion of the image display panel 1 and the dam portion 3 that surrounds the outer periphery of the fill portion 4, not only is a difference between the refractive index of the photocured product of the (meth)acrylic acid ester component as the component (a) and the refractive index of the plasticizer component as the component (b) in the dam portion 3 set preferably to 0.02 or less, more preferably 0.015 or less, but also a difference between the refractive index of the photocured product of the (meth)acrylic acid ester component as the component (a) and the refractive index of the plasticizer component as the component (b) in the fill portion 4 is preferably set to 0.02 or less, more preferably 0.015 or less. This can make it possible to make it difficult to visually recognize the knit line at the boundary line between the dam portion 3 and the fill portion 4. Furthermore, in order to make it more difficult to visually recognize the knit line, the difference between the refractive index of the photocured product of the (meth)acrylic ester component as the component (a) in the dam portion 3 and the refractive index of the photocured product of the (meth)acrylic ester component as the component (a) in the fill portion 4 is preferably set to 0.02 or less, more preferably 0.015 or less, and the difference between the refractive index of the plasticizer component as the component (b) in the dam portion 3 and the refractive index of the plasticizer component as the component (b) in the fill portion 4 is also preferably set to 0.02 or less, more preferably 0.015 or less.

(Image display panel 1)

Examples of the image display panel 1 constituting the image display device 10 include a liquid crystal display panel, an organic EL display panel, and a touch panel. Here, the touch panel means an image display and input panel in which a display element such as a liquid crystal display panel and a position input device such as a touch pad are combined with each other.

(Front panel 2)

The front panel 2 constituting the image display device 10 of the present invention functions as a protective panel of the image display panel 1. Examples of the front panel 2 include a plate-like material and a sheet-like material, made of glass, an acrylic resin, a polyethylene terephthalate, a polyethylene naphthalate, a polycarbonate, and the like. These materials may be subjected to a hard coat treatment, an antireflection treatment, or the like on one side or both sides. The thickness and the physical properties such as an elastic modulus of the front panel 2 can be appropriately determined according to the purpose of use. Note that the front panel 2 includes not only a relatively simple member having the above-described configuration but also a laminated member such as a touch panel module in which various sheets or film materials are laminated.

A light-shielding layer (not shown) may be provided at a peripheral portion of the front panel 2 to improve the contrast of an image. The light-shielding layer can be formed, for example, by applying a coating material colored in black or the like by a screen printing method or the like, and drying and curing the coating material. The thickness of the light-shielding layer is usually 5 to 100 $\mu$m.

(Transparent resin layer 5)

The transparent resin layer 5 of the image display device 10 of the present invention includes the dam portion 3 and the fill portion 4. The dam portion 3 is provided on the outer periphery of the image display panel, and the fill portion 4 is filled inside the dam portion 3. The dam portion 3 is usually a continuous structure with a size of 0.3 mm to 3 mm in width and 0.1 mm to 2 mm in height. In addition, when a metal bezel (not shown) is provided at the outer edge of the image display panel 1, a different dam portion, which is generally a continuous structure with a size of 0.3 mm to 3 mm in width and 0.1 mm to 2 mm in height, may be provided at the border between the metal bezel and the image display panel.

(Polarizing plate 6)

The polarizing plate 6 is formed by sandwiching a polarizer (not shown) between a pair of protective layers (not shown). An adhesive may be used for sandwiching the polarizer. The polarizing plate 6 may further include other optical layers (for example, a retardation plate) other than the polarizer and the protective layer. The thickness of the polarizing plate 6 is usually 0.1 mm to 0.3 mm.

As the polarizer, for example, a polarizer having a known configuration obtained by subjecting a polyvinyl alcohol-based resin to a dyeing treatment with a dichroic substance (for example, an iodine compound) and a stretching treatment can be used.

Examples of the protective layers that sandwich the polarizer include films made of a thermoplastic resin excellent in transparency, mechanical strength, thermal stability, moisture blocking property, isotropy, and the like. Examples of such thermoplastic resins include a cellulose resin such as triacetyl cellulose (TAC), a polyester resin such as polyethylene terephthalate (PET) and polyethylene naphthalate (PEN), a polyether sulfone resin, a polysulfone resin, a polycarbonate resin, a polyamide resin, a polyimide resin, a polyolefin resin, a (meth)acrylic resin, a cyclic polyolefin resin, a polyarylate resin, a polystyrene resin, a polyvinyl alcohol resin, and a mixture thereof.

<Method for producing image display device>

The image display device of the present invention shown in FIG. 1 can be produced as described below, but is not limited thereto.

First, the polarizing plate is disposed on one side of the image display panel according to a conventional method, and the photocurable material of the present invention is applied, in a dam shape, to the periphery thereof by a dispenser or the like. Then, the photocurable material is irradiated with ultraviolet rays to form a photocurable dam portion.

Next, the photocurable material for forming the fill portion is applied to a region that is surrounded by the photocurable dam portion by a dispenser or the like and then dried to form a photocurable fill portion. Thus, the photocurable resin layer composed of the photocurable dam portion and the photocurable fill portion is formed.

Subsequently, the front panel is laminated on the photocurable resin layer.

Finally, the photocurable resin layer is irradiated with ultraviolet rays through the front panel to be photocured. As a result, a photocured transparent resin layer is formed, thereby obtaining the image display device of FIG. 1.

[Examples]

Hereinafter, the present invention will be described in detail with reference to Examples and Comparative Examples. The compounds used in the following Examples and Comparative Examples are as follows.

<Component (a), (meth)acrylic acid ester component>

(Oligomer)

Polyether-based oligomer: UV-3700B (urethane acrylate oligomer, manufactured by Mitsubishi Chemical Corporation).

(Monomer)

Hydroxyl group-containing monomer: 4-HBA (4-hydroxybutyl acrylate, manufactured by Osaka Organic Chemical Industry Ltd.);
Cyclic group-containing monomer: Viscoat 200 (Cyclic trimethylolpropane formal acrylate, manufactured by Osaka Organic Chemical Industry Ltd.);
Ether group-containing monomer: Viscoat 190 (ethoxyethoxyethyl acrylate, manufactured by Osaka Organic Chemical Industry Ltd.);
Alkyl group-containing monomer: IDAA (isodecyl acrylate, manufactured by Osaka Organic Chemical Industry Ltd.).

<Component (b), plasticizer component>

Polyether-based plasticizer: Adeka Polyether P-3000 (PO adduct of propylene glycol, manufactured by ADEKA Corporation);
Hydroxyl group-containing polymer: ELFORT 3122L (a polymer of 2-ethylhexyl acrylate and hydroxyethyl acrylate, manufactured by Showa Denko Materials Co., Ltd.)

<Component (c), photopolymerization initiator component>

Phosphine oxide-based photopolymerization initiator: SPEEDCURE TPO (2,4,6-trimethylbenzoyldiphenylphosphine oxide, manufactured by Lambson Ltd.).

<Component (d), filler>

Surface untreated silica: AEROSIL 200 (fumed silica, manufactured by Nippon Aerosil Co., Ltd.);
Hydrophobic surface-treated silica: VP NKC130 (Fumed silica surface-treated with hexadecyl group-containing silane (C16 alkyl group-containing silane compound), manufactured by Nippon Aerosil Co., Ltd.).

Examples 1 to 3 and Comparative Examples 1 to 2

The components (a) to (d) shown in Table 1 were uniformly mixed according to a conventional method to prepare photocurable materials for the dam portion and for the fill portion.

(Visibility evaluation of knit line)

Table 1 shows the results of visibility evaluation performed by visual observation of the knit line at the boundary line between the dam portion and the fill portion of the transparent resin layer of the image display device having the structure shown in FIG. 1. The results were obtained for each of Examples and Comparative Examples.

[Table 1]

| Components | Name of Compound | Refractive Index (after curing) | Comparative Example 1 Photocurable Material (parts by mass) | | Comparative Example 2 Photocurable Material (parts by mass) | | Example 1 Photocurable Material (parts by mass) | | Example 2 Photocurable Material (parts by mass) | | Example 3 Photocurable Material (parts by mass) | |
|---|---|---|---|---|---|---|---|---|---|---|---|---|
| | | | For Dam Portion | For Fill Portion | For Dam Portion | For Fill Portion | For Dam Portion | For Fill Portion | For Dam Portion | For Fill Portion | For Dam Portion | For Fill Portion |
| (a) (Meth)Acrylic Acid Ester Component | Polyether-Based Oligomer, UV-3700B | 1.4611 | 23.0 | 23.0 | 23.0 | 23.0 | 23.0 | 23.0 | 23.0 | 20.6 | 23.0 | 23.0 |
| | Hydroxyl Group-Containing Monomer, 4-HBA | 1.4814 | 5.1 | 5.1 | 5.1 | 5.1 | | | | | 5.1 | 5.1 |
| | Cyclic Group-Containing Monomer, Viscost200 | 1.4863 | 23.0 | 23.0 | | | | | | | | |
| | Ether Group-Containing Monomer, Viscoat 190 | 1.4683 | | | 23.0 | 23.0 | 28.0 | 28.0 | 28.0 | 20.5 | 23.0 | 23.0 |
| | Alkyl Group-Containing Monomer, IDAA | 1.4687 | | | | | 7.0 | 7.0 | 7.0 | 7.7 | | |
| | [Difference in Refractive Index within Component (a)] → | | 0.0252 | 0.0252 | 0.0203 | 0.0203 | 0.0076 | 0.0086 | 0.0076 | 0.0076 | 0.0203 | 0.0203 |
| | A: [Refractive Index of Photocured Product of Entire Component (a)] → | | 1.4801 | 1.4801 | 1.4699 | 1.4699 | 1.4659 | 1.4659 | 1.4659 | 1.4653 | 1.4699 | 1.4699 |

| Components | Name of Compound | Refractive Index (after cuing) | Comparative Example 1 Photocurable Material (parts by mass) | | Comparative Example 2 Photocurable Material (parts by mass) | | Example 1 Photocurable Material (parts by mass) | | Example 2 Photocuable Material (parts by mass) | | Example 3 Photocuable Material (parts by mass) | |
|---|---|---|---|---|---|---|---|---|---|---|---|---|
| | | | For Dam Portion | For Fill Portion | For Dam Portion | For Fill Portion | For Dam Portion | For Fill Portion | For Dam Portion | For Fill Portion | For Dam Portion | For Fill Portion |
| (b) Plasticizer Component | Polyether-Based Plasticizer, Adeka Polyether P-3000 | 1.4494 | 48.5 | 48.5 | 48.5 | 48.5 | 13.0 | 13.0 | 13.0 | 14.3 | 38.5 | 38.5 |
| | Hydroxyl Group-Containing Polymer, ELFORT 3122L | 1.4768 | | | | | 28.0 | 28.0 | 28.0 | 30.9 | 100 | 100 |
| | [Difference in Refractive Index within Component (b)]→ | | 0 | 0 | 0 | 0 | 0.0274 | 0.0274 | 0.0274 | 0.0274 | 0.0274 | 0.0274 |
| | B: [Total Refractive Index of Component (b)] → | | 1.4494 | 1.4494 | 1.4494 | 1.4494 | 1.4681 | 1.4681 | 1.4681 | 1.4681 | 1.4550 | 1.4550 |
| (c) Photopolymerization Initiator Component | Phosphine Oxide-Based Photopolymerization Initiator, SPEEDCURE TPO | | 0.5 | 0.5 | 0.5 | 0.5 | 10 | 10 | 1.0 | 0.4 | 0.5 | 0.5 |
| (d) Filler | Surface Untreated Silica: AEROSIL 200 | | | | | | | | | | 2.8 | |
| | Hydrophobt Surface-Treated Silica: VP NKC130 | | | | | | | | | | 2.8 | |
| Difference in Refractive Index \|A-B\| | | | 0.0307 | 0.0307 | 0.0205 | 0.0205 | 0.0022 | 0.0022 | 0.0022 | 0.0028 | 0.0149 | 0.0149 |

EP 4 393 971 A1

13

(continued)

| Components | Name of Compound | Comparative Example 1 Photocurable Material (parts by mass) | | Comparative Example 2 Photocurable Material (parts by mass) | | Example 1 Photocurable Material (parts by mass) | | Example 2 Photocurable Material (parts by mass) | | Example 3 Photocurable Material (parts by mass) | |
|---|---|---|---|---|---|---|---|---|---|---|---|
| | | For Dam Portion | For Fill Portion | For Dam Portion | For Fill Portion | For Dam Portion | For Fill Portion | For Dam Portion | For Fill Portion | For Dam Portion | For Fill Portion |
| | Refractive Index (after cuing) | | | | | | | | | | |
| Visbility Evaluation of Knit Line | | Poor (Knit line was visually recognized) | | Poor (Knit line was visually recognized) | | Good (Knit line was not visually recognized) | | Good (Knit line was not visually recognized) | | Good (Knit line was not visually recognized) | |

14

(Discussion of evaluation results)

As can be understood from Table 1, regarding the difference between the refractive index of the photocured product of the entire component (a) and the refractive index of the component (b), values of less than 0.02 were obtained with the photocurable materials of Examples 1 to 3, and thus the knit line was not visually recognized. In particular, since the difference values in the photocurable materials of Examples 1 and 2 were significantly lower than 0.02, it is expected that the visibility of the knit line is lower than that of the photocurable material of Example 3.

On the other hand, the difference between the refractive index of the photocured product of the entire component (a) and the refractive index of the component (b) exceeded 0.02 with the photocurable materials of Comparative Examples 1 and 2, and thus the knit line was visually recognized.

[Industrial applicability]

The photocurable material of the present invention contains the component (a), which is the (meth)acrylic acid ester component, the component (b), which is a plasticizer component, and the component (c), which is a photopolymerization initiator component. In the photocurable material, the difference between the refractive index of the photocured product of the component (a), which is the (meth)acrylic acid ester component, and the refractive index of the component (b), which is the plasticizer component, is 0.02 or less. Therefore, when the photocurable material of the present invention is applied to the formation of a transparent resin layer of the image display device in which an image display panel and a front panel are laminated via the transparent resin layer, it can be expected that the boundary line between the dam portion and the fill portion of the transparent resin layer is difficult to visually recognize as a knit line. Therefore, the photocurable material of the present invention is useful in the production of various types of image display devices.

Reference Signs List

1    image display panel
2    front panel
3    dam portion
4    fill portion
5    transparent resin layer
6    polarizing plate
10   image display device

**Claims**

1. A photocurable material for forming a transparent resin layer of an image display device, in which an image display panel and a front panel are laminated via the transparent resin layer, the photocurable material comprising the following components (a) to (c):

   a component (a) being a (meth)acrylic acid ester component;
   a component (b) being a plasticizer component; and
   a component (c) being a photopolymerization initiator component,
   wherein the photocurable material of a difference between a refractive index of a photocured product of the (meth)acrylic acid ester component as the component (a) and a refractive index of the plasticizer component as the component (b) is 0.02 or less.

2. The photocurable material according to claim 1, wherein the (meth)acrylic acid ester component as the component (a) is obtained by mixing 0.5 parts by mass to 1.0 part by mass of the photopolymerization initiator component as the component (c) with 100 parts by mass of (meth)acrylic acid ester component to form a mixture, and photocuring the mixture.

3. The photocurable material according to claim 1 or 2, wherein the (meth)acrylic acid ester component as the component (a) contains one or more types of polyfunctional (meth)acrylate oligomers and one or more types of monofunctional (meth)acrylate monomers.

4. The photocurable material according to claim 3, wherein the polyfunctional (meth)acrylate oligomer is a bifunctional polyether-based urethane (meth)acrylate oligomer, and the monofunctional (meth)acrylate monomer is a hydroxy group-containing (meth)acrylate monomer.

5. The photocurable material according to any one of claims 1 to 4, wherein a difference in refractive index between photocured products of the respective oligomers and the respective monomers in the (meth)acrylic acid ester component as the component (a) is 0.02 or less.

6. The photocurable material according to any one of claims 1 to 5, wherein when the plasticizer component as the component (b) contains a plurality of plasticizers, a refractive index of the plasticizer component as the component (b) is a numerical value obtained by first multiplying a refractive index of each plasticizer of the plurality of plasticizers by an abundance (parts by mass) thereof to obtain a numerical value, and second dividing a numerical value, obtained by adding all the numerical values obtained for the respective plasticizers, by a total of the abundances of the plurality of plasticizers.

7. The photocurable material according to any one of claims 1 to 6, wherein when the plasticizer component as the component (b) contains a first plasticizer having a refractive index RIa and a second plasticizer having a refractive index RIb, and an abundance of the first plasticizer is W1 parts by mass and an abundance of the second plasticizer is W2 parts by mass, a refractive index of the plasticizer component as the component (b) is calculated according to the following equation:

Refractive index of component (b), which is plasticizer component = (RIa × W1 + RIb × W2)/(W1 + W2).

8. The photocurable material according to any one of claims 1 to 7, wherein when the plasticizer component as the component (b) contains a plurality of plasticizers, a difference in refractive index between the plasticizers is 0.03 or less.

9. The photocurable material according to any one of claims 1 to 8, further comprising a filler as a component (d) when the photocurable material is used for forming a dam portion in a case where the transparent resin layer is composed of a fill portion present at a position corresponding to a display portion of the image display panel and the dam portion surrounding an outer periphery of the fill portion.

10. An image display device comprising an image display panel and a front panel that are laminated via a transparent resin layer, wherein the transparent resin layer is a potocured product of the photocurable material according to any one of claims 1 to 9.

11. An image display device, wherein when the transparent resin layer is composed of a fill portion present at a position corresponding to a display portion of an image display panel and a dam portion surrounding an outer periphery of the fill portion, a difference between a refractive index of a photocured product of the (meth)acrylic acid ester component as the component (a) and a refractive index of the plasticizer component as the component (b) in the photocurable material according to any one of claims 1 to 9 for forming the dam portion is 0.02 or less, and a difference between a refractive index of the photocured product of the (meth)acrylic acid ester component as the component (a) and a refractive index of the plasticizer component as the component (b) in the photocurable material according to any one of claims 1 to 9 for forming the fill portion is 0.02 or less.

12. The image display device according to claim 11, wherein a difference between the refractive index of the photocured product of the (meth)acrylic ester component as the component (a) in the dam portion and the refractive index of the photocured product of the (meth)acrylic ester component as the component (a) in the fill portion is 0.02 or less, and a difference between the refractive index of the plasticizer component as the component (b) in the dam portion and the refractive index of the plasticizer component as the component (b) in the fill portion is 0.02 or less.

# FIG. 1

<table>
<tr><td colspan="2" align="center"><b>INTERNATIONAL SEARCH REPORT</b></td><td>International application No.<br><br><b>PCT/JP2022/031233</b></td></tr>
</table>

**A.      CLASSIFICATION OF SUBJECT MATTER**

*C08F 290/06*(2006.01)i; *C09J 4/02*(2006.01)i; *C09J 11/06*(2006.01)i; *C09J 11/08*(2006.01)i; *C08F 2/44*(2006.01)i; *G09F 9/00*(2006.01)i
FI:    G09F9/00 313; C09J4/02; C09J11/06; C09J11/08; C08F2/44 B; C08F290/06

According to International Patent Classification (IPC) or to both national classification and IPC

**B.      FIELDS SEARCHED**

Minimum documentation searched (classification system followed by classification symbols)

      C08F290/06; C09J4/02; C09J11/06; C09J11/08; C08F2/44; G09F9/00

Documentation searched other than minimum documentation to the extent that such documents are included in the fields searched

      Published examined utility model applications of Japan 1922-1996
      Published unexamined utility model applications of Japan 1971-2022
      Registered utility model specifications of Japan 1996-2022
      Published registered utility model applications of Japan 1994-2022

Electronic data base consulted during the international search (name of data base and, where practicable, search terms used)

**C.      DOCUMENTS CONSIDERED TO BE RELEVANT**

| Category* | Citation of document, with indication, where appropriate, of the relevant passages | Relevant to claim No. |
|---|---|---|
| X | JP 2018-140601 A (DEXERIALS CORP) 13 September 2018 (2018-09-13)<br>    paragraphs [0025], [0040], [0049] | 12 |
| A | WO 2018/110666 A1 (DENKA COMPANY LIMITED) 21 June 2018 (2018-06-21)<br>    entire text, all drawings | 1-12 |
| A | WO 2016/039289 A1 (DENKI KAGAKU KOGYO KABUSHIKI KAISHA) 17 March 2016<br>(2016-03-17)<br>    entire text, all drawings | 1-12 |
| A | WO 2014/168173 A1 (DENKI KAGAKU KOGYO KABUSHIKI KAISHA) 16 October 2014<br>(2014-10-16)<br>    entire text, all drawings | 1-12 |
| A | JP 2014-148606 A (DENKI KAGAKU KOGYO KABUSHIKI KAISHA) 21 August 2014<br>(2014-08-21)<br>    entire text, all drawings | 1-12 |

☑ Further documents are listed in the continuation of Box C.     ☑ See patent family annex.

| | |
|---|---|
| *   Special categories of cited documents:<br>"A"  document defining the general state of the art which is not considered to be of particular relevance<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| Date of the actual completion of the international search | Date of mailing of the international search report |
|---|---|
| **31 October 2022** | **08 November 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**EP 4 393 971 A1**

<table>
<tr><td colspan="2" align="center"><b>INTERNATIONAL SEARCH REPORT</b></td><td>International application No.<br><b>PCT/JP2022/031233</b></td></tr>
</table>

**C.    DOCUMENTS CONSIDERED TO BE RELEVANT**

| Category* | Citation of document, with indication, where appropriate, of the relevant passages | Relevant to claim No. |
|:---:|---|:---:|
| A | WO 2014/046182 A1 (MITSUBISHI RAYON CO., LTD.) 27 March 2014 (2014-03-27)<br>entire text, all drawings | 1-12 |
| A | US 2010/0302641 A1 (LU, Zhijian) 02 December 2010 (2010-12-02)<br>entire text, all drawings | 1-12 |

Form PCT/ISA/210 (second sheet) (January 2015)

19

**INTERNATIONAL SEARCH REPORT**
Information on patent family members

International application No.

**PCT/JP2022/031233**

| Patent document cited in search report | | | Publication date (day/month/year) | Patent family member(s) | | | Publication date (day/month/year) |
|---|---|---|---|---|---|---|---|
| JP | 2018-140601 | A | 13 September 2018 | JP | 2022-508 | A | |
| | | | | WO | 2018/159110 | A1 | |
| | | | | paragraphs [0025], [0040], [0049] | | | |
| | | | | TW | 201834848 | A | |
| | | | | KR | 10-2019-0072606 | A | |
| | | | | CN | 110234506 | A | |
| | | | | CN | 113372823 | A | |
| | | | | KR | 10-2021-0130272 | A | |
| WO | 2018/110666 | A1 | 21 June 2018 | CN | 110088159 | A | |
| | | | | KR | 10-2019-0092486 | A | |
| WO | 2016/039289 | A1 | 17 March 2016 | TW | 201624124 | A | |
| WO | 2014/168173 | A1 | 16 October 2014 | TW | 201446915 | A | |
| JP | 2014-148606 | A | 21 August 2014 | (Family: none) | | | |
| WO | 2014/046182 | A1 | 27 March 2014 | TW | 201420718 | A | |
| US | 2010/0302641 | A1 | 02 December 2010 | JP | 2009-544990 | A | |
| | | | | US | 2010/0112490 | A1 | |
| | | | | US | 2008/0020291 | A1 | |
| | | | | WO | 2008/011497 | A2 | |
| | | | | KR | 10-2009-0033178 | A | |
| | | | | CN | 101523288 | A | |

Form PCT/ISA/210 (patent family annex) (January 2015)

**REFERENCES CITED IN THE DESCRIPTION**

**Patent documents cited in the description**

- WO 2014168173 A